# EUROPEAN PATENT APPLICATION

(11) **EP 4 125 113 A1**
(43) Date of publication of application: **01.02.2023**
(21) Application number: 21188690.8
(22) Date of filing: 30.07.2021
(51) Int. Cl.: H01L 21/02

(54) **METHOD FOR FABRICATING A GAN BASED ELECTRONIC DEVICE**

(71) Applicant: Imec VZW, 3001 Leuven (BE); Universiteit Hasselt, 3500 Hasselt (BE)
(72) Inventor: Mallik, Awadesh, 3500 Hasselt (BE)
(74) Representative: Roth, Sebastian

(57) **Abstract**

The disclosure relates to a method for fabricating a gallium nitride, GaN, based electronic device. The method comprises the steps of:
- providing a substrate (11), wherein at least a surface of the substrate (11) is formed from a GaN material;
- forming a first diamond layer (13) on the surface of the substrate (11), wherein the first diamond layer (13) is a nanocrystalline diamond layer, and wherein the first diamond layer (13) is in physical contact with the surface of the substrate (11); and
- forming a second diamond layer (15) on the first diamond layer (13), wherein the second diamond layer (15) is a polycrystalline diamond layer.

## Description

### TECHNICAL FIELD

The present disclosure relates to the thermal management of gallium nitride (GaN) based electronic devices. In particular, the present disclosure relates to a method for fabricating a GaN based electronic device and to a structure for a GaN based electronic device.

### BACKGROUND

Recently, silicon (Si) is getting replaced in high power, high frequency and high temperature electronics by wide bandgap semiconductors such as GaN. However, the thermal conductivity of GaN is not high enough for effective dissipation of the heat that is generated within such high power electronic devices. Therefore, it would be preferable to combine GaN with a highly heat conducting material such as diamond in order to achieve efficient cooling of the device.

Due to its high thermal conductivity, diamond is highly suitable as heat conducting material for high power electronic devices. However, combining GaN directly with diamond is difficult for various reasons, such as the incapability of GaN to form carbides and the mismatch of the thermal expansion coefficients of GaN and diamond (5-7 ppm/K for GaN vs. 0.8 ppm/K for diamond). In addition, GaN and diamond exhibit large differences in their respective elastic modulus (1.14×10¹² GPa for diamond vs. 2.94×10¹¹ GPa for GaN) and Poisson's ratio (0.07 for diamond vs. 0.25 for GaN). These intrinsic differences between GaN and diamond can lead to a delamination of a diamond layer from a GaN substrate. In particular, such delamination is increasingly more likely at thicknesses of the diamond layer required for efficient heat dissipation (e.g., above 10 µm).

Generally, diamond layers can be deposited via chemical vapor deposition (CVD). Metastable growth of a diamond layer by CVD typically occurs at temperatures between 700°C and i,200°C. However, GaN is prone to etching at temperatures beyond 600°C. Thus, a GaN substrate can be damaged during CVD deposition of diamond, which is another hurdle of using diamond for the thermal management of GaN based electronics. The temperature window of 700°-1,200°C for metastable CVD growth of diamond is also detrimental for many other low melting point substrates, for example many polymers.

In order to mitigate the mismatch of the physical properties of GaN and diamond and to prevent damaging of a GaN substrate during diamond deposition, it is known to use intermediate buffer layers, e.g. nitride layer such as SiN, AlN or AlGaN, on top of the GaN substrate. Such non-diamond buffer layers can generate a more gradual transition of the lattice parameters from GaN to diamond and can protect the GaN surface from damages during high temperature diamond deposition. However, such buffer layers between GaN and diamond can have a detrimental effect on the heat dissipation from GaN to diamond. For example, nitride buffer layers are not fully effective in avoiding phonon scattering at the interfacial boundaries, thus reducing the thermal management efficiency of the diamond layer. Further, nitride buffer layers have a low thermal conductivity and would act as thermal insulation or thermal barrier and, thus, would hinder the heat dissipation from GaN to diamond. For these reasons, it would be advantageous if such buffer layers could be dispensed with.

### SUMMARY

Thus, it is an objective to provide an improved method for fabricating a GaN based electronic device and an improved structure for a GaN based electronic device. In particular, the above-mentioned disadvantages should be avoided.

The objective is achieved by the embodiments provided in the enclosed independent claims. Advantageous implementations of the embodiments of the invention are further defined in the dependent claims.

According to a first aspect, the present disclosure relates to a method for fabricating a gallium nitride, GaN, based electronic device, comprising:
- providing a substrate, wherein at least a surface of the substrate is formed from a GaN material;
- forming a first diamond layer on the surface of the substrate, wherein the first diamond layer is a nanocrystalline diamond layer, and wherein the first diamond layer is in physical contact with the surface of the substrate; and
- forming a second diamond layer on the first diamond layer, wherein the second diamond layer is a polycrystalline diamond layer.

This achieves the advantage that a stable diamond coating can be generated directly on a GaN surface of a GaN based electronic device. This diamond coating can facilitate heat dissipation from the substrate of the device.

The nanocrystalline diamond layer can form a diamond-interlayer in-between the GaN surface and the polycrystalline diamond layer, which can be a microcrystalline diamond layer. Thus, thin film deposition problems such as film delamination or internal stresses that would occur at an interface of the GaN surface and the polycrystalline diamond layer can be avoided. The polycrystalline diamond layer can be a microcrystalline diamond layer.

In particular, the nanocrystalline diamond layer can form a more stable bond with the GaN layer than the polycrystalline diamond layer.

In particular, there is no non-diamond buffer layer or interlayer, such as a SiN layer (which are mostly amorphous layers), in-between the GaN surface and the diamond layers. Thus, reduced heat dissipation due to non-diamond material layers between GaN and diamond can be avoided.

The GaN based electronic device can be a high-electron-mobility-transistor (HEMT) or a structure of a GaN based HEMT.

In particular, polycrystalline diamond layer refers to a material layer that mostly comprises diamond grains with varying grain sizes typically in the micron range or larger, e.g. > 1 µm. In contrast, nanocrystalline diamond layer refers to a material layer that mostly comprises diamond grains with grain sizes in the nanometer range, e.g. 5-100 nm.

In an embodiment, the second diamond layer is a microcrystalline diamond layer. This achieves the advantage that a diamond coating suitable for thermal management of the electronic device can be provided.

In particular, microcrystalline diamond layer refers to a material layer that mostly comprises diamond grains with grain sizes in the micron range, e.g. 1-5 µm.

The microcrystalline diamond layer can be deposited at a high growth rate, e.g. 1-2 µm/h. Thus, a sufficiently thick diamond layer for heat dissipation can be produced in a relatively short time.

In an embodiment, the substrate is a GaN wafer or a section of a GaN wafer.

In an embodiment, the first diamond layer forms a continuous layer on the substrate and covers the surface of the substrate. This achieves the advantage that a uniform diamond intermediate layer can be formed between the GaN surface and the polycrystalline diamond, which can efficiently prevent delamination of the polycrystalline diamond and, at the same time, does not negatively affect heat dissipation.

In an embodiment, the first diamond layer has a lower thickness than the second diamond layer. This achieves the advantage that the first diamond layer forms a highly stable layer on the GaN surface with low risk of delamination, while the second diamond layer can be thick enough to provide efficient heat dissipation.

In an embodiment, the first diamond layer has a thickness of less than 100 nm, preferably of less than 50 nm.

For example, the second diamond layer can have a thickness of 50 µm or more.

In an embodiment, the first diamond layer and the second diamond layer are formed by two separate deposition steps with different process parameters, in particular at different temperatures. This achieves the advantage that both diamond layers can be generated efficiently under controlled conditions while avoiding damages to the GaN surface.

In an embodiment, during the formation of the first diamond layer, a temperature of the substrate is 800°C or less, in particular is 500°C or less. This achieves the advantage that damages to the GaN surface during deposition of the first diamond layer can be avoided.

In particular, a growth temperature of the first diamond layer does not exceed 800°C. In this way, unwanted damages to the GaN surface that would occur above 800°C can be avoided. Furthermore, when the polycrystalline diamond layer is deposited at higher temperatures in a subsequent step, the GaN surface can be protected by the nanocrystalline layer.

In an embodiment, the first diamond layer is formed by a plasma enhanced chemical vapor deposition (PECVD) process. This achieves the advantage that the first diamond layer can be generated efficiently.

In an embodiment, the temperature of the substrate is controlled by a deliberate manipulation of one or more operating parameters of a PECVD reactor carrying out the PECVD process, wherein the one or more operating parameters of the PECVD reactor comprise: a microwave input power and/or a distance of a microwave plasma source to the substrate. This achieves the advantage that the first diamond layer can be efficiently generated in a controlled manner and at low temperatures.

For example, the distance of a microwave plasma source to the substrate can be controlled by adjusting the position, in particular height, of a stage for the substrate within the PECVD reactor during the CVD deposition process.

In particular, the PECVD reactor used to form the first diamond layer is a linear antenna microwave plasma enhanced CVD reactor. The microwave plasma source can comprise a linear antenna in a quartz tube.

In an embodiment, prior to the formation of the first diamond layer via the PECVD process, a diamond seeding material is deposited on the surface of the substrate.

In particular, a plasma treatment can be performed on the surface of the substrate prior to depositing the seeding material. This achieves that the first diamond layer can be generated efficiently.

In an embodiment, the second diamond layer is formed in a resonant cavity plasma enhanced chemical vapor deposition (PECVD) reactor. The resonant cavity PECVD reactor can be a resonant cavity microwave plasma CVD (MPCVD) reactor, e.g. a 2.45 GHz MPCVD reactor.

In particular, both diamond layers can be formed in PECVD reactors. The first diamond layer can be formed in a linear antenna PECVD reactor and the second diamond layer can be formed in a resonant cavity PECVD reactor.

A GaN based electronic device processed with the method of the first aspect shows clear "fingerprints" of that method. For example, the nanocrystalline diamond layer is directly arranged on the GaN surface without any non-diamond interlayers and forms a stable bond with the GaN surface. The polycrystalline diamond layer is arranged on top of the nanocrystalline diamond layer. In case the nanocrystalline diamond layer is deposited at temperatures below 800°C, e.g. at ca. 600°C, the GaN surface does, for instance, not exhibit characteristic modifications due to high temperature etching.

According to a second aspect, the present disclosure relates to a structure for a GaN based electronic device, comprising: a substrate, wherein at least a surface of the substrate is formed from a GaN material; a first diamond layer on the surface of the substrate, wherein the first diamond layer is a nanocrystalline diamond layer, and wherein the first diamond layer is in physical contact with the surface of the substrate; and a second diamond layer on the first diamond layer, wherein the second diamond layer is a polycrystalline diamond layer.

This achieves the advantage that GaN based electronic device can be provided with a stable diamond coating on a GaN surface of the device. This diamond coating can facilitate heat dissipation from the substrate of the device.

The nanocrystalline diamond layer can form a diamond-interlayer in-between the GaN surface and the polycrystalline diamond layer. Thus, thin film deposition problems such as film delamination or internal stresses that would occur at an interface of the GaN and the polycrystalline diamond layer can be avoided.

In particular, there is no non-diamond buffer layer or interlayer, such as a SiN layer, in-between the GaN surface and the crystalline layers. Thus, reduced heat dissipation due to non-diamond material layers between GaN and diamond can be avoided.

The structure can be a section of the GaN based electronic device. The structure can also form to the entire GaN based electronic device.

In an embodiment, the GaN based electronic device is a GaN based high-electron-mobility-transistor (HEMT).

In an embodiment, the second diamond layer is a microcrystalline diamond layer.

In an embodiment, the first diamond layer forms a continuous layer on the substrate and covers the surface of the substrate.

In an embodiment, the substrate is a GaN wafer or a section of a GaN wafer.

In an embodiment, the first diamond layer has a lower thickness than the second diamond layer.

In an embodiment, the first diamond layer has a thickness of less than 100 nm, preferably of less than 50 nm. The second diamond layer can have a thickness of 50 µm or more.

### BRIEF DESCRIPTION OF THE DRAWINGS

Embodiments of the invention will be explained in the followings together with the figures.
- Figs. 1a-c: shows steps of a method for fabricating a GaN based electronic device according to an embodiment;
- Fig. 2: shows a flowchart of a method for generating a nanocrystalline diamond layer on a GaN surface according to an embodiment; and
- Fig. 3: shows a schematic diagram of a structure for a GaN based electronic device according to an embodiment.

### DETAILED DESCRIPTION OF THE PREFERRED EMBODIMENTS

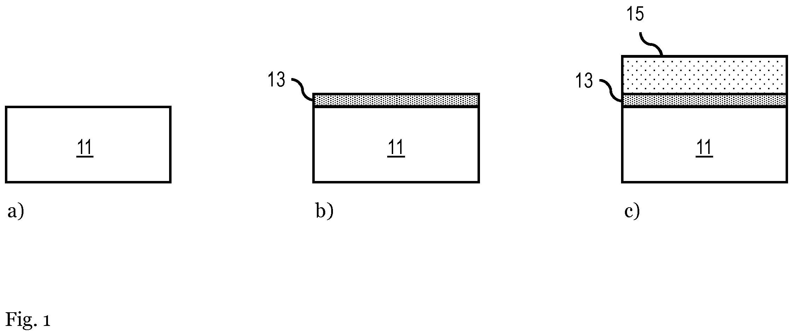

Figs. 1a-c show steps of a method for fabricating a GaN based electronic device according to an embodiment.

The method shown in Figs. 1a-c can be used to fabricate a single GaN based electronic device or a plurality of GaN based electronic devices in parallel. The method can also be used to fabricate a structure or section of a GaN based electronic device.

The method comprises, as shown in Fig. 1a, providing a substrate 11, wherein at least a surface of the substrate 11 is formed from a GaN material.

The substrate 11 can be a GaN wafer or a section of a GaN wafer. The substrate 11 can also be a GaN coated structure, e.g. a GaN coated sapphire wafer.

In a subsequent step, shown in Fig 1b, a first diamond layer 13 is formed on the surface of the substrate 11, wherein the first diamond layer 13 is a nanocrystalline diamond layer, and wherein the first diamond layer 13 is in physical contact with the surface of the substrate 11.

The first diamond layer 13 can, thereby, form a continuous layer on the substrate 11 and can cover the surface of the substrate 11. In particular, the first diamond layer 13 does not form separate nanocrystalline diamond "islands" that are not connected with each other.

The first diamond layer 13 can have a thickness of less than 100 nm, preferably of less than 50 nm. For example, the thickness of the first diamond layer 13 is ca. 45 nm. The relatively low thickness of the first diamond layer 13 reduces the risk of delamination from the GaN surface, which would be increasingly more likely at thicknesses of the diamond layer of several microns. At the same time, a diamond layer with a thickness below 100 nm can be deposited relatively quickly.

In a further step, shown in Fig 1c, the method comprises forming a second diamond layer 15 on the first diamond layer 13, wherein the second diamond layer 15 is a polycrystalline diamond layer.

The polycrystalline diamond layer 15 can be a microcrystalline diamond layer. The polycrystalline (second) diamond layer 15 can be in direct physical contact with the first diamond layer 13.

In particular, the first diamond layer 13 forms a diamond-interlayer in-between the GaN surface and the second diamond layer 15 in order to reduce film deposition problems such as film delamination or substrate bow due to internal stresses that would occur at an interface of the GaN and the polycrystalline diamond layer 15.

The first diamond layer 13 and the second diamond layer 15 can be formed by two separate deposition steps with different process parameters, in particular at different temperatures. For example, during the formation of the first diamond layer 13, a temperature of the substrate is 800°C or less, in particular is 500°C or less. In contrast, the second diamond layer 15 can be generated by a standard CVD diamond growth process at temperatures exceeding 800°C. In this way, unwanted damages to the GaN surface that may occur at temperatures above 800°C can be avoided, because the first diamond layer 13 is deposited at lower temperatures and the GaN surface is protected by the first diamond layer 13 when the second diamond layer 15 is formed. The second diamond layer 15 can be formed by a conventional CVD diamond growth process, e.g. in a resonant cavity microwave plasma CVD reactor.

For example, the temperature window suitable for metastable growth of CVD diamond is between 700°C and i,200°C. However, many inorganic substrates, such as GaN, are reactive at such high temperature. GaN is prone to etching beyond 600°C. In principle, the following three possible reactions occur in a CVD growth environment at these high temperatures:
1. 2N(surface) + 3H2 (g) = 2NH3 (g) - at 800°C
2. 2Ga(surface) + H2 (g) = 2GaH (g) - at 800°C
3. 2GaN(s) = Ga(1) + N2(g) - above 800°C

Thus, when deposit diamond directly on GaN at these temperatures above 800°C, there will be a competition between the rate of diamond deposition and GaN substrate etching. Hence, by depositing the first (nanocrystalline) diamond layer 13 at temperatures below 800°C, unwanted damages to the GaN surface can be avoided.

In particular, the first diamond layer is formed by a plasma enhanced chemical vapor deposition (PECVD) process. This PECVD process can be carried out by a linear antenna microwave plasma enhanced CVD reactor.

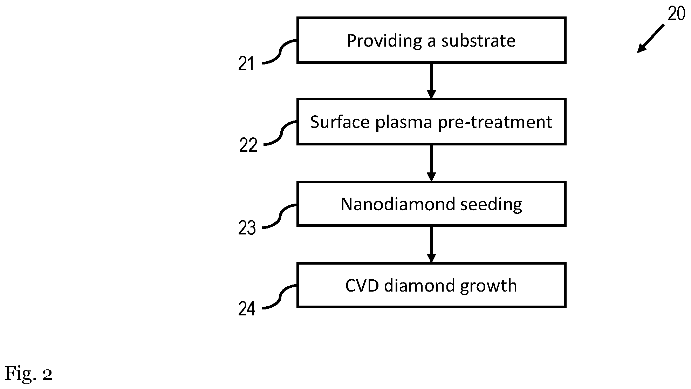

Fig. 2 shows a flowchart of a method 20 for generating the nanocrystalline diamond layer on the GaN surface according to an embodiment. The method shown in Fig. 2 can be used to form the first diamond layer 13 according to Fig. 1b.

The method 20 comprises a first step 21 of providing the substrate 11, wherein the substrate has a GaN surface.

The method 20, further, comprises a step 22 of performing a surface plasma pre-treatment to the substrate 11, e.g. using a CF₄ plasma. In a subsequent step 23, a diamond seeding is performed on the surface of the substrate 11. By means of the plasma pre-treatment step 22, the surface of the substrate 11 can be modified to enhance this nanocrystalline diamond seeding. The diamond seeding step 23 may comprise spin-coating the diamond seeding material on the GaN surface of the substrate and, subsequently, washing any excess seeding material off the substrate, such that a uniform dispersion of seeding material is formed on the substrate.

In particular, such seeding also helps the growth of a well adherent nanodiamond (i.e., nanocrystalline diamond) layer on GaN by linear antenna CVD. Linear antenna CVD allows the growth of scattered nanodiamond seeds on the GaN surface into a fully coalesced nanocrystalline diamond layer. In this way, the resonant cavity CVD, which is performed to deposit the subsequent poly- or microcrystalline diamond layer, cannot attack the GaN substrate surface throughout any gaps in between the nanodiamond seed particles that are present after the nanodiamond seeding step.

In a final step 24 of the method 20, a CVD growth of the nanocrystalline diamond layer on the GaN surface is performed. The CVD growth process can be a PECVD process which is carried out by a linear antenna microwave plasma enhanced CVD (LA MW PE CVD) reactor.

In particular, during CVD growth of the nanocrystalline diamond layer, the temperature of the substrate is 800°C or less. The temperature of the substrate can, thereby, be controlled by a deliberate manipulation of one or more operating parameters of the PECVD reactor carrying out the PECVD process. The one or more operating parameters of the PECVD reactor can comprise: a microwave input power and/or a distance of a microwave plasma source to the substrate.

Preferably, the LA MW PE CVD reactor comprises a reaction chamber which can be flooded with a reaction gas. The substrate can be arranged on a stage in the reaction chamber adjacent to a linear antenna. The linear antenna can be arranged in a quartz tube. The antenna can be connected to a microwave generator which can provide a microwave input power to the antenna. The powered antenna in the quartz tube can be configured to generate and heat a plasma in the reaction chamber. An example for such a linear antenna microwave plasma source is disclosed in H. Schlemm, A. Mai, S. Roth, D. Roth, K.-M. Baumgartner, H. Muegge, Surface & Coatings Technology 174-175 (2003) 208-211.

By the use of the LA MW PE CVD reactor and, particularly, by manipulating its process parameters, the nanocrystalline diamond layer can be deposited on GaN in a controlled manner at relatively low temperatures. During the deposition, the distance between the quartz tube (plasma source) and the substrate stage were varied, e.g. between 3 and 15 cm. Varying this distance directly affects the substrate 11 temperature, which can be kept between 415°C and 300°C depending on the distance. For example, the GaN surface temperature can be monitored and controlled by changing the stage-height via a lever outside of the CVD reactor. This "in-situ stage adjustment" can help to avoid chemical degradation of the GaN surface under the CVD plasma environment. In addition, the microwave input power can be altered, e.g. from 1.5 to 2.8 kW, to attain low substrate 11 temperatures. For example, 300°C is the lower temperature limit, which can be attained by heating only with the microwave plasma, when the substrate 11 is kept farthest (e.g., 15 cm) away from the liner antenna quartz tube and with the maximum amount of input microwave power. Sole heating by microwave plasma takes time to attain the final substrate temperature; therefore, an additional stage heater can be used to more rapidly achieve the minimum substrate temperature of 300°C for efficient growth of diamond in the sp3 phase. At the same time, a pulse mode frequency of the microwave input power can be used to optimize the quality of the diamond film (e.g., 20 kHz, 45% duty cycle). For example, the nanocrystalline diamond can be deposited in the LA MW PE CVD reactor from a H₂/CH_{4/}CO₂ gas mixture at pressures of less than one Torr, e.g. 0.2 mTorr.

In particular, plasma formation is used to generate both the first and the second diamond layer 13, 15. The main difference between resonant cavity plasma CVD (used to generate the poly-/microcrystalline diamond layer) and linear antenna plasma CVD (used to generate the nanocrystalline diamond layer) is their electromagnetic wave location/position conducive for plasma formation. The resonant cavity can confine the electromagnetic wave and thereby the CVD plasma within a small spherical volume, whereas the surface wave plasma propagates along a quartz tube inside the linear antenna plasma enhanced CVD reactor, which allows the formation of plasma throughout the whole volume of the CVD chamber. The conventional CVD has a very high plasma density which allows rapid growth of micro/polycrystalline diamond, whereas, the plasma density is relatively low inside linear antenna CVD which leads to slower growth of nanocrystalline diamond.

For example, the surface and cross-sectional microstructure of the deposited nanocrystalline diamond layer, which can vary between facetted and plate like to cauliflower like, can be observed under a scanning electron microscope and an elemental analysis of the film surfaces can be done by electron diffraction spectroscopy. Moreover, the diamond film quality and crystallinity can be evaluated by Raman spectroscopy. Different LA MW PE CVD reactor parameters, such as antenna to stage distances, microwave input power in continuous wave mode or in pulse mode, which directly affect the substrate temperatures, can have significant impact on the growth of the nanocrystalline diamond layer in terms of quality and structure. An optimal quality of the nanocrystalline diamond film on the GaN surface without GaN etching is, for example, achieved under pulse mode (20 kHz, 45% duty cycle) 2 kW average input microwave power.

Subsequent to the deposition of the nanocrystalline diamond layer, the thicker polycrystalline diamond layer can be deposited on top of the nanocrystalline diamond layer via an alternative CVD growth process, e.g. using a resonant cavity microwave plasma enhanced CVD process.

This two-step process of subsequently growing nanocrystalline and polycrystalline diamond layers on GaN has several advantages over depositing a diamond layer with a single deposition step: i) GaN etching by CVD plasma processing can be reduced; ii) no nitride intermediate buffer layers (e.g., SiN or AlN) between diamond and GaN, which would limit heat dissipation, are required; iii) problems of diamond film adhesion can be avoided (such problems can occur when diamond is directly grown over non-carbide forming substrates such as GaN, due to the differences in the crystal structure and/or thermal expansion co-efficient which may cause deposited film delamination after the diamond film becomes several microns thick); and iv) long processing times due to slow growth rates of diamond can be avoided, thereby saving time.

In particular, the first two advantages, i.e. reduced GaN etching and omitting intermediate nitride layers, can be achieved by depositing the thin nanocrystalline diamond film as first layer on the GaN surface using a linear antenna microwave plasma enhanced CVD (LA MW PE CVD) reactor. Via suitable manipulation of the process parameters of this reactor, the deposition of the nanocrystalline diamond directly on the GaN surface without GaN etching can be achieved. LA MW PE CVD is a relatively slow process with a diamond growth rate of ca. 45 nm/h. However, since the nanocrystalline diamond layer is deposited at a relatively low thickness (typically < 100 nm), this low deposition rate is not an issue. The polycrystalline diamond layer on top can be deposited at much large deposition rates by means of a conventional CVD reactor, e.g. a 2.45 GHz CVD reactor. Due to the nanocrystalline diamond layer, which forms a protective layer on top of the GaN surface, CVD high temperature hydrogen plasma GaN etching in the conventional CVD reactor can be avoided.

For example, LA MW PE CVD of nanocrystalline diamond directly on the GaN surface is performed for 1-2 hours. The nanocrystalline diamond coated GaN substrate can then be taken to a conventional 2.45 GHz CVD chamber for subsequent growth of microcrystalline diamonds, which can be performed for 1-3 hours.

The nanocrystalline diamond layer can form a thin diamond buffer layer in-between the GaN surface and the polycrystalline diamond layer. Such a diamond buffer layer is advantageous over a non-diamond layer, .e.g. a nanometer thick SiN or AlN layer, because these nitride layers are amorphous and therefore exhibit a poor thermal conductivity. In particular, the nanocrystalline diamond layer not only protects the GaN surface from the CVD plasma environment during subsequent deposition of the thicker polycrystalline diamond layer 15, but also facilitates smooth integration of said polycrystalline diamond layer on top of the nanocrystalline diamond layer.

In particular, this two-step process is advantageous over other techniques to deposit diamond on GaN. For example, Ga and C can in principle be bonded using techniques such as Ar sputtering and joining, spark plasma sintering, or H-terminated diamond seeding. However, there are film adhesion problems associated with these direct growth techniques, i.e. the diamond films delaminate from the GaN surface. Moreover, when using conventional CVD deposition techniques, the harsh CVD processing conditions inside the CVD reactor can lead to etching of the GaN surface due to chemical reactions with the hydrogen plasma. However, by using the LA MW PE CVD technique to directly deposit a thin layer (40-50 nm) of nanocrystalline diamond on GaN, unwanted GaN etching can be avoided. Subsequent to the nanocyrstalline diamond deposition, the microcrystalline diamond can be deposited at higher growth rates (e.g., 1-2µm/h) using a 2.45 GHz microwave plasma enhanced CVD reactor.

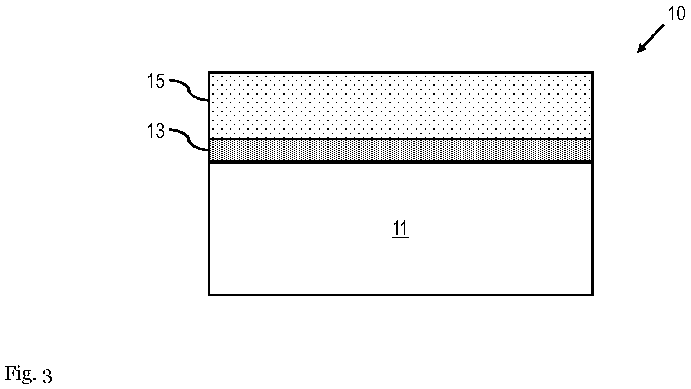

Fig. 3 shows a schematic diagram of a structure 10 for a GaN based electronic device according to an embodiment.

The structure 10 comprises the substrate 11, wherein at least the surface of the substrate 11 is formed from the GaN material, and the first diamond layer 13 on the surface of the substrate 11, wherein the first diamond layer 13 is a nanocrystalline diamond layer, and wherein the first diamond layer 13 is in physical contact with the surface of the substrate 11. The structure 10 further comprises the second diamond layer 15 on the first diamond layer 13, wherein the second diamond layer 15 is a polycrystalline diamond layer.

The GaN based electronic device can be a power electronic device. GaN is increasingly replacing silicon in many high power, high frequency and high temperature electronics. In particular, GaN and diamond are both wide band gap semiconductors with band gap values of 3.44 eV and 5.45 eV, respectively. Diamond has better electron mobility (2200 cm²/Vs) than doped GaN (900 cm²/Vs). The hole mobility of diamond is ca. 1800 cm²/Vs and, thus, larger than that of GaN, which is ca. 10 cm²/Vs. Silicon has a comparatively low break down field of ca. 3×10⁵ V/cm and an intrinsic band gap of 1.12 eV with electron and hole mobilities of 1400 and 450 cm²/Vs, respectively. Silicon has a thermal expansion coefficient of 2.6 ppm/K with thermal conductivity of 130 W/m-K, closely matching with GaN but widely different from diamond. The critical break down field is the best for diamond 6×10⁶ V/cm, while GaN is almost half of that value at 3×10⁶ V/cm.

The structure 10 can be a section of the GaN based electronic device, e.g. a GaN based HEMT. In particular, the diamond layer layers 13, 15 can be arranged on a backside of a HEMT substrate, on the opposite side of source, drain and gate structures of the HEMT. The structure 10 can also form the entire GaN based electronic device.

The first diamond layer 13 can form a continuous layer on the substrate 11 and can cover the surface of the substrate 11. In particular, the first diamond layer 13 forms a thin diamond interlayer in-between the GaN surface and the second diamond layer 15.

For example, the first diamond layer 13 has a thickness of less than 100 nm, preferably of less than 50 nm, while the second diamond layer 15 has a thickness of more than 5 µm. The second diamond layer 15 can be a microcrystalline diamond layer.

The diamond layers 13, 15 can facilitate dissipation of heat that is generated due to flow of current through the GaN based electronic devices such that the device can perform efficiently for long time periods. The primary obstacle of combining GaN and diamond is their difference in crystal lattices and unmatching thermal expansion coefficients. In principle, these differences could be overcome by putting non-diamond intermediate transition layers, such as SiN, AlN, AlGaN or SiC layers, in between GaN and diamond. However, these non-diamond layers generally have a low thermal conductivity and therefore act as thermal insulator or thermal barrier in between GaN substrate and diamond coating. In other words, they hinder the heat dissipation away from the substrate. Therefore, it is advantageous to omit any non-diamond intermediate buffer layers and directly grow diamond on the substrate 11.

## Claims

1. A method for fabricating a gallium nitride, GaN, based electronic device, comprising:
- providing a substrate (11), wherein at least a surface of the substrate (11) is formed from a GaN material;
- forming a first diamond layer (13) on the surface of the substrate (11), wherein the first diamond layer (13) is a nanocrystalline diamond layer, and wherein the first diamond layer (13) is in physical contact with the surface of the substrate (11); and
- forming a second diamond layer (15) on the first diamond layer (13), wherein the second diamond layer (15) is a polycrystalline diamond layer.

2. The method of claim 1,
wherein the second diamond layer (15) is a microcrystalline diamond layer.

3. The method of claim 1 or 2,
wherein the substrate (11) is a GaN wafer or a section of a GaN wafer.

4. The method of any one of the preceding claims,
wherein the first diamond layer (13) forms a continuous layer on the substrate (11) and covers the surface of the substrate (11).

5. The method of any one of the preceding claims,
wherein the first diamond layer (13) has a lower thickness than the second diamond layer (15).

6. The method of any one of the preceding claims,
wherein the first diamond layer (13) has a thickness of less than 100 nm, preferably of less than 50 nm.

7. The method of any one of the preceding claims,
wherein the first diamond layer (13) and the second diamond layer (15) are formed by two separate deposition steps with different process parameters, in particular at different temperatures.

8. The method of any one of the preceding claims,
wherein, during the formation of the first diamond layer (13), a temperature of the substrate (11) is 800°C or less, in particular is 500°C or less.

9. The method of any one of the preceding claims,
wherein the first diamond layer (13) is formed by a plasma enhanced chemical vapor deposition, PECVD, process.

10. The method of claims 8 and 9,
wherein the temperature of the substrate (11) is controlled by a deliberate manipulation of one or more operating parameters of a PECVD reactor carrying out the PECVD process, wherein the one or more operating parameters of the PECVD reactor comprise: a microwave input power and/or a distance of a microwave plasma source to the substrate (11).

11. The method of claim 9 or 10,
wherein prior to the formation of the first diamond layer (13) via the PECVD process, a diamond seeding material is deposited on the surface of the substrate (11).

12. The method of any one of the preceding claims,
wherein the second diamond layer (15) is formed in a resonant cavity plasma enhanced chemical vapor deposition, PECVD, reactor.

13. A structure (10) for a GaN based electronic device, comprising:
a substrate (11), wherein at least a surface of the substrate (11) is formed from a GaN material;
a first diamond layer (13) on the surface of the substrate (11), wherein the first diamond layer (13) is a nanocrystalline diamond layer, and wherein the first diamond layer (13) is in physical contact with the surface of the substrate (11); and
a second diamond layer (15) on the first diamond layer (13), wherein the second diamond layer (15) is a polycrystalline diamond layer.

14. The structure (10) of claim 13,
wherein the GaN based electronic device is a GaN based high-electron-mobility-transistor, HEMT.

15. The structure (10) of claim 13 or 14,
wherein the first diamond layer (13) forms a continuous layer on the substrate (11) and covers the surface of the substrate (11).
